# EUROPEAN PATENT SPECIFICATION

(11) **EP 0 693 783 B1**
(45) Date of publication and mention of the grant of the patent: **22.09.1999**
(21) Application number: 94305122.7
(22) Date of filing: 13.07.1994
(51) Int. Cl.: H01L 27/02

(54) **Method for eliminating process antenna effect**
Verfahren zur Eliminierung des Antenneneffekts während der Fabrikation
Procédé pour l'élimination de l'effet d'antenne pendant la fabrication

(43) Date of publication of application: 24.01.1996
(73) Proprietor: UNITED MICROELECTRONICS CORPORATION, Science-Based Industrial Park, Hsinchu City (TW)
(72) Inventor: Hsu, Bill, Chu-Pei City, Hsin-Chu County (TW); Ko, Joe, Hsin-Chu (TW)
(74) Representative: Overbury, Richard Douglas

(56) References cited:
- EP-A- 0 431 490
- EP-A- 0 490 506
- GB-A- 2 174 543
- US-A- 4 941 028
- Symp. VLSI Tech. May '89, pgs. 73-74, Shone et al.

## Description

The present invention relates to the manufacture of highly dense integrated circuits, and more particularly to the elimination of electrostatic charge build-up at the device during manufacture during, for example, plasma etching or the like process steps.

In the manufacture of highly dense integrated circuits using Metal Oxide Semiconductor (MOS) technology with multiple metal layers, electrical charge may build up at the device gate oxide during plasma processing. The charge accumulates on floating polysilicon and metal layers electrically connected to the gate oxide. Interconnection metal lines act as an "antenna", amplifying the charging effect and leading to trapped charges at the gate oxide. These trapped charges can cause yield loss and reliability failures.

Workers in the field have verified this problem experimentally. It has been found that the double metal layer technologies worsen the effect by the ratio of the antenna area to the gate oxide area. The worst degradation of gate oxide occurs during oxynitride deposition. However other plasma processing is also believed to lead to trapped charges at the gate oxide.

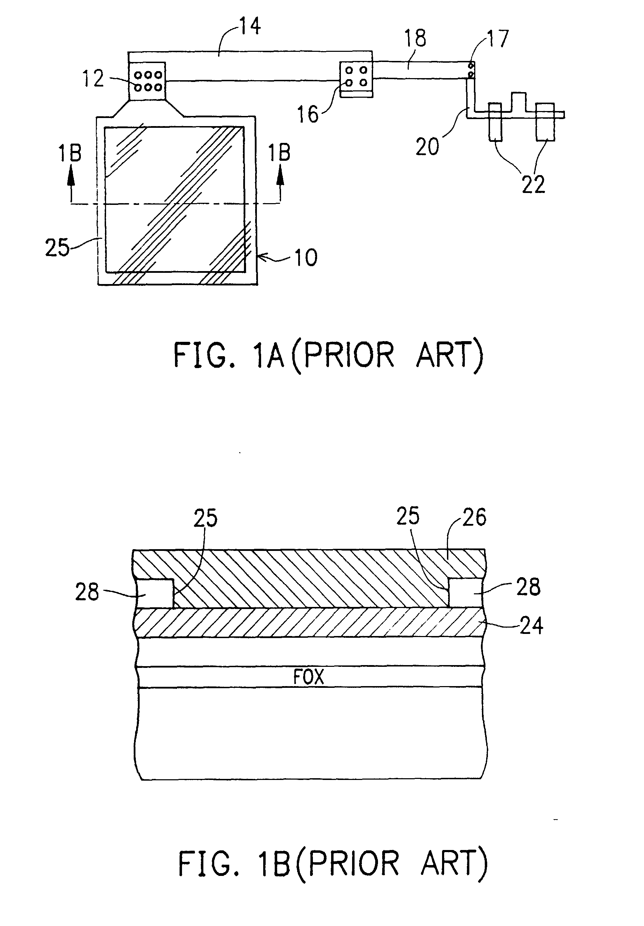

Referring now to Figs. 1A and 1B, there are shown schematic diagrams of a prior process for connecting a large contact pad with an active MOS device by using a metal layer, which could lead to device damage due to the antenna effect. As can be seen in Fig. 1A, in the manufacture of MOS semiconductor devices, a large contact pad area 10 (of typical size 100 by 100 micrometers, and more than about 30 by 30 micrometers) is electrically connected by vias 12 to a polysilicon interconnection 14. The pad area 10 in a double metal process would consist of two layers 24 and 26 of metal, as shown in Fig. 1B. The upper metal layer or metal II, 26 is connected through an insulating layer 28 to the lower metal layer, or metal I, 24 by a large via 25 which generally has a size less than 5 micrometers smaller than the large contact pad area 10. The polysilicon interconnection 14 is connected by vias 16 in an insulating layer to metal interconnection 18. This metal interconnection 18 is connected by vias 17 to polysilicon 20 and thence to active devices 22. There is a direct electrical connection between all elements, and charge accumulated during plasma processing on the polysilicon and large metal areas can lead to damage to the devices due to trapped charges. More specifically, charge will be induced and accumulated on the exposed lower metal layer 24 through the large via 25 in the pre-sputter etching step before the upper metal layer 26 is sputtered. The induced charge can lead to damage to the devices 22 via the direct electrical connection path comprising the lower metal layer 24, the polysilicon interconnection 14, the metal interconnection 18 and the polysilicon 20. In addition, the greater the size of the large via 25, the greater the amount of the charge induced and accumulated.

It is common in the manufacture of integrated circuits today to use plasma etching, plasma enhanced chemical vapor deposition, and sputtering technologies. See VLSI Technology, S. M. Sze., Chapter 5 - Reactive Plasma Etching pages 184-189, Chapter 6 - Dielectric and Polysilicon Film Deposition pages 235-238, Chapter 9 - Metallization pages 386-391, published by McGraw-Hill International Editions 1988 in Singapore. A plasma is a collection of charged particles, including electrons and positive and negative ions, and it is these charged particles that collect along the conductive surfaces during plasma processing, and may produce the trapped charges damaging the gate oxide.

It is a primary object of the present invention to provide a method for eliminating the antenna effect of accumulated electrical charge on floating polysilicon and metal interconnections connected to the gate oxide, without additional process steps. This is accomplished by isolating the polysilicon and metal interconnections from the gate oxide during plasma processing.

EP 0 490 506 describes a semiconductor device having an interconnection structure comprising an insulating layer and a metal interconnection layer wherein a part of the metal interconnection layer is formed as a bonding pad portion. The bonding pad portion is disposed in a hall formed in the insulating layer and a part of the metal interconnection layer is spaced from the bonding pad portion and covers the side of the hall.

GB-A-2 174 543 describes a package containing a semiconductor or integrated circuit chip having enlarged electrodes for soldering to bent electrically conductive leads so as to improve the reliability of the electrical connection.

In Symp. VLSI Tech May 89, p73-74, Shone et al describe techniques for eliminating gate oxide charging. These techniques include subjecting the wafers to longer alloy cycles, depositing a thin dielectric layer on the wafers before oxynitride deposition, and attaching a substrate diode to the antenna. There is no suggestion to reduce gate oxide charging by isolating the interconnections from the gate oxide during processing. Moreover there is no disclosure of contact pads at the device periphery.

In accordance with the present invention there is provided a method of subjecting an MOS integrated circuit, having large first metal regions on its surfaces which are electrically connected to the device structures, to a plasma process, said method comprising the following sequence of steps :
(a) forming an electrical discontinuity in the connection between the large first metal regions and the device structures thereby electrically isolating the large first metal regions from the device structures; (b) placing the integrated circuit in a chamber for accomplishing the plasma process; (c) subjecting the integrated circuit to a plasma process wherein the discontinuity between the large first metal regions and the device structures prevents damage to the device structures; (d) removing the integrated circuit from the chamber; and (e) electrically re-connecting the large first metal regions to the device structures by means of another metal layer.

In a particularly preferred embodiment the method is used in a method of forming a multi-level conductive interconnection for an integrated circuit in a silicon substrate wherein the large first metal regions are in the form of large contact pad areas at the periphery of the interconnection. This forming method comprises:
forming a patterned layer of a conductive polysilicon on the silicon substrate to act as a first conductive contact to the integrated circuit;
forming an insulating layer over the polysilicon layer;
forming openings to the polysilicon layer through the insulating layer;
forming a layer of metal on the insulating layer such that the metal layer electrically connects to the polysilicon through the openings;
forming the large contact pad areas with the said metal layer;
patterning the metal layer to form the electrical discontinuity therein which electrically isolates the large contact pad areas and the integrated circuit to prevent charge build-up during subsequent processing;
further processing in a plasma environment that would normally produce electrical charge build-up at the gate oxide of the integrated circuit, but wherein the electrical discontinuity prevents the charge build-up;
forming and patterning another insulating layer to form openings for vias to the metal layer;
forming another layer of metal over the large contact pad areas and over the electrical discontinuity such that said another metal layer electrically connects to the first metal layer, via direct contact to said metal layer at the large contact pad areas and through the openings in said another insulating layer to the first metal interconnection, thereby electrically re-connecting the large contact pad areas and the integrated circuit; and
forming a passivation layer over said another metal layer.

In accordance with one aspect of the present invention, the processing in the plasma environment is plasma enhanced chemical vapor deposition, plasma etching, or sputter etch. The size of the large contact pad areas is preferably greater than about 30 x 30 micrometers, and preferably the large contact pad areas are located at the periphery of the integrated circuit.

In accordance with another embodiment of the present invention, the method further comprises the steps of patterning said another metal layer at the electrical discontinuity to form a second electrical discontinuity; further processing in a plasma environment that would normally produce an electrical charge build-up at the gate oxide of the integrated circuit, but wherein the second electrical discontinuity prevents the charge build-up; forming and patterning a further insulating layer to form openings for vias to said another metal layer; forming a further layer of metal over the large contact pad areas and over the second electrical discontinuity such that the further metal layer electrically connects to said another metal layer, via direct contact to said another metal layer at the large contact pad areas and through the openings in said further insulating layer thereby electrically re-connecting the large contact pad areas and the integrated circuit; and forming the passivation layer over said further metal layer. Additional metal layers may be added in a similar way.

For a better understanding of the invention and to show how the same may be carried into effect, reference will now be made, by way of example to the accompanying drawings in which:-
Figs. 1A and 1B illustrate a prior process for connecting a large contact pad with an active MOS device by using a metal layer which could lead to device damage due to the antenna effect,
Figs. 2A through 2C illustrate the process of the present invention for eliminating the antenna effect in a double metal structure by using an electrical discontinuity in the first metal layer, and
Fig. 3 illustrates a further embodiment of the present invention for a triple metal structure.

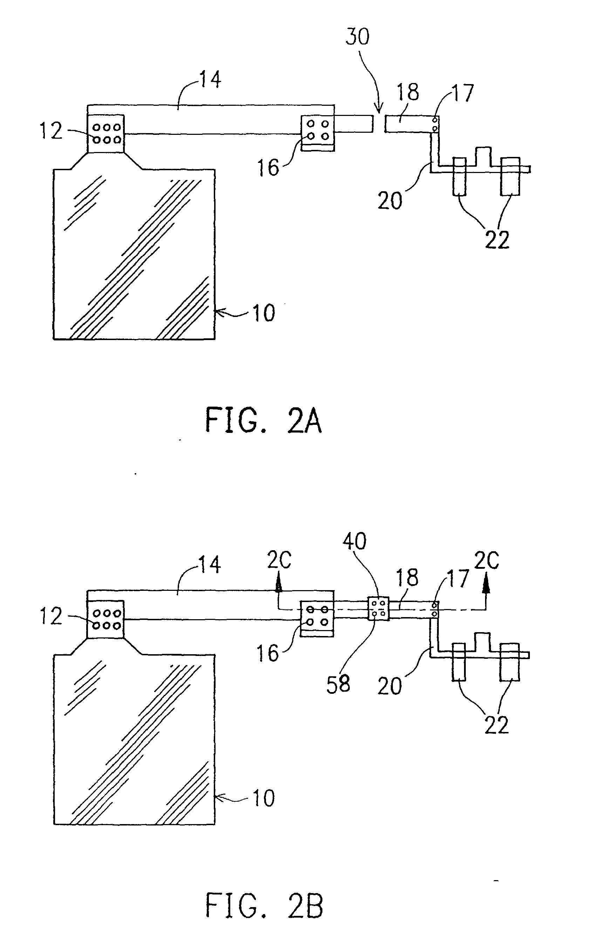

Referring now to Fig. 2A, there is shown the preferred embodiment of the present invention. After a first metal, metal I, has been deposited in areas 10 and 18, an electrical discontinuity 30 is patterned in the metal I interconnection. Any charge accumulated during subsequent plasma processing steps on the pad side of the electrical discontinuity 30, particularly on the large pad area 10, will not affect the devices 22.

Referring now to Fig. 2B, a second metal layer, metal II, has been added to areas 10 and 30 and to form connection 40 through vias 58 to close the electrical discontinuity 30. This is done by a small mask change in the via and metal II mask used for lithography, etching, and patterning of the via and metal II layer. The second metal layer connection 40 is connected through an insulating layer and vias 58 to re-establish the electrical connection between the large pad area 10 and devices 22, after plasma processing has been completed.

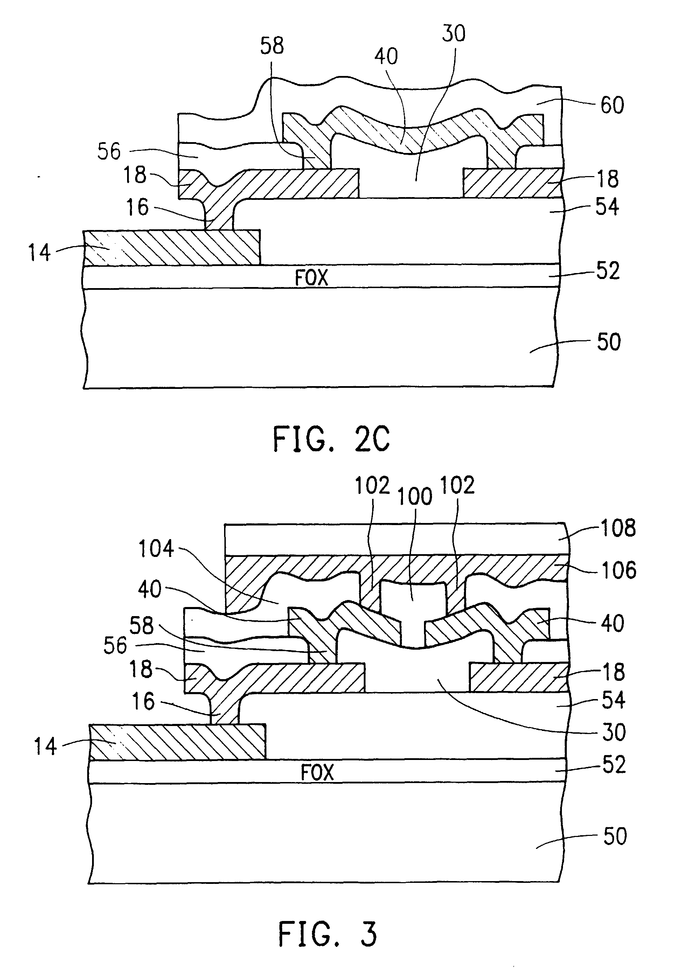

Referring now to Fig. 2C, there is shown a cross-sectional representation of the electrical discontinuity and re-connection. Field oxide (FOX) 52 was thermally grown on substrate 50, and polysilicon 14 was deposited and patterned on the field oxide 52. Vias 16 were opened through insulating layer 54, typically by wet or dry etching, and a first metal layer 18 was deposited such that it connected through vias 16 to polysilicon 14. Electrical discontinuity 30 was then patterned by conventional lithography and etching in the first metal layer 18 to break the electrical connection between the pad area 10 and devices 22. Subsequent plasma processing steps were then effected without accumulating charge and causing the antenna effect. Vias 58 were patterned through insulating layer 56, and a second metal layer 40 was deposited to re-connect the first metal layer 18 and re-establish the electrical connection from the pad area 10 to devices 22. Finally. a passivation layer 60 was deposited on the second layer metal 40.

Referring now to Fig. 3, there is shown a cross-sectional representation of an electrical break in two levels of metal for a three-level metal technology. Field oxide 52 was thermally grown on substrate 50, and polysilicon 14 was patterned by conventional lithography and etching on the field oxide 52. Vias 16 were patterned by lithography and etching through insulating layer 54, and first metal layer 18 was deposited and patterned by conventional lithography and etching such that it connected through vias 16 to polysilicon 14. Electrical discontinuity 30 was patterned in the first metal layer 18 to break the connection between the pad area 10 and devices 22. Subsequent plasma processing steps were then effected without accumulating charge and causing the antenna effect. Vias 58 were patterned through insulating layer 56, and a second metal layer 40 was deposited to re-connect the first metal layer 18. Electrical discontinuity 100 was further patterned by lithography and etching in the second metal layer 40 to maintain isolation between the pad area 10 and devices 22. Further plasma processing steps were then effected without accumulating charge and causing the antenna effect. Vias 102 were patterned by lithography and etching through insulating layer 104, and a third metal layer 106 was deposited and patterned to re-connect the second metal layer 40 and re-establish the electrical connection from the pad area 10 to devices 22. Finally, a passivation layer 108 was deposited on the third metal layer 106.

## Claims

1. A method of subjecting an MOS integrated circuit, having large first metal regions (10) on its surfaces which are electrically connected to the device structures (22), to a plasma process, said method comprising the following sequence of steps :
(a) forming an electrical discontinuity (30) (100) in the connection (18) (40) between the large first metal regions and the device structures thereby electrically isolating the large first metal regions from the device structures;
(b) placing the integrated circuit in a chamber for accomplishing the plasma process;
(c) subjecting the integrated circuit to a plasma process wherein the discontinuity between the large first metal regions and the device structures prevents damage to the device structures;
(d) removing the integrated circuit from the chamber; and
(e) electrically re-connecting the large first metal regions to the device structures by means of another metal layer (40)(106).

2. The method as claimed in claim 1, wherein the size of the large first metal regions is greater than about 30 x 30 micrometers.

3. The method as claimed in claim 1 or 2, wherein another metal layer and the first metal regions are separated by an insulating material (56)(104), through which vias (58)(102) are formed to re-connect the large first metal regions to the device structures.

4. The method as claimed in claim 1, 2 or 3, wherein the large first metal regions constitute pads located at the periphery of the integrated circuit.

5. A method of forming a multi-level conductive interconnection utilising the method of claim 4, which interconnection forming method comprises:
forming a patterned layer of conductive polysilicon (14) on a silicon substrate (50) to act as a first conductive contact to the integrated circuit;
forming an insulating layer (54) over the polysilicon layer;
forming openings to the polysilicon layer through the insulating layer;
forming a layer (18) of metal on the insulating layer such that the metal layer electrically connects to the polysilicon through the openings;
forming said large contact pad areas with said metal layer;
patterning the metal layer to form the electrical discontinuity (30) therein which electrically isolates the large contact pad areas and the integrated circuit to prevent charge build-up during subsequent processing;
further processing in a plasma environment that would normally produce electrical charge build-up at the gate oxide of the integrated circuit, but wherein the electrical discontinuity prevents the charge build-up;
forming and patterning another insulating layer (56) to form openings for said vias (58) to the metal layer;
forming another layer (40) of metal over the large contact pad areas and over the electrical discontinuity such that said another metal layer electrically connects to the first metal layer, via direct contact to said metal layer at the large contact pad areas and through the openings in said another insulating layer thereby electrically re-connecting the large contact pad areas and the integrated circuit; and
forming a passivation layer (60) over said another metal layer.

6. The method as claimed in claim 5, wherein the processing in a plasma environment is plasma enhanced chemical vapor deposition.

7. The method as claimed in claim 5, wherein the processing in a plasma environment is plasma etching.

8. The method as claimed in claim 7, wherein the plasma etching is a sputter etch.

9. The method as claimed in any of claims 5 to 8, wherein said another metal layer is patterned to form a second electrical discontinuity (100) between the large contact pad areas and the integrated circuit;
further processing in a plasma environment that would normally produce an electrical charge build-up at the gate oxide of the integrated circuit, but wherein the second electrical discontinuity prevents the charge build up;
forming and patterning a further insulating layer (104) to form openings for via (102) to said another metal layer;
forming a further layer (106) of metal over the large contact pad areas and over the second electrical discontinuity such that said further metal layer electrically connects to said another metal layer, via direct contact to said another metal layer at the large contact pad areas and through the openings in said further insulating layer thereby electrically re-connecting the large contact pad areas and the integrated circuit; and forming the passivation layer over said further metal layer.

## Patentansprüche

1. Verfahren, bei dem man eine integrierte MOS-Schaltung, die große erste Metallbereiche (10) auf ihren Oberflächen aufweist, die elektrisch mit den Strukturen (22) der Vorrichtung verbunden sind, einer Plasmaverarbeitung unterzieht, wobei das Verfahren den folgenden Schrittablauf umfaßt:
a) Ausbilden einer elektrischen Unterbrechung (30) (100) in der Verbindung (18) (40) zwischen den großen ersten Metallbereichen und den Strukturen der Vorrichtung, wodurch die großen ersten Metallbereiche elektrisch gegen die Strukturen der Vorrichtung isoliert werden;
b) Anordnen der integrierten Schaltung in einer Kammer, in der die Plasmaverarbeitung erfolgt;
c) Anwenden einer Plasmaverarbeitung auf die integrierte Schaltung, wobei die Unterbrechung zwischen den großen ersten Metallbereichen und den Strukturen der Vorrichtung verhindert, daß die Strukturen der Vorrichtung beschädigt werden;
d) Entfernen der integrierten Schaltung aus der Kammer; und
e) elektrisches Wiederverbinden der großen ersten Metallbereiche mit den Strukturen der Vorrichtung mit Hilfe einer weiteren Metallschicht (40) (106).

2. Verfahren nach Anspruch 1, wobei die Abmessung der großen ersten Metallbereiche größer ist als ungefähr 30 x 30 Mikrometer.

3. Verfahren nach Anspruch 1 oder 2, wobei eine weitere Metallschicht und die ersten Metallbereiche durch ein Isoliermaterial (56) (104) getrennt sind, durch das Durchverbindungen (58) (102) ausgebildet werden, um die großen ersten Metallbereiche wieder mit den Strukturen der Vorrichtung zu verbinden.

4. Verfahren nach Anspruch 1, 2 oder 3, wobei die großen ersten Metallbereiche Anschlußflächen bilden, die am Rand der integrierten Schaltung angeordnet sind.

5. Verfahren zum Ausbilden einer mehrstufigen leitenden Verbindung mit Hilfe des Verfahrens nach Anspruch 4, wobei das Verfahren zum Verbindungsausbilden umfaßt:
das Ausbilden einer strukturierten Schicht aus leitendem Polysilizium (14), die als erster leitender Kontakt zur integrierten Schaltung wirkt, auf einem Siliziumsubstrat (50);
das Ausbilden einer Isolierschicht (54) über der Polysiliziumschicht;
das Ausbilden von Öffnungen zur Polysiliziumschicht durch die Isolierschicht;
das Ausbilden einer Schicht (18) aus Metall auf der Isolierschicht, so daß die Metallschicht durch die Öffnungen eine elektrische Verbindung zum Polysilizium hat;
das Ausbilden der großen Anschlußflächenbereiche mit der Metallschicht;
das Strukturieren der Metallschicht, um in ihr die elektrische Unterbrechung (30) auszubilden, die die großen Anschlußflächenbereiche elektrisch gegen die integrierte Schaltung isoliert, damit sich bei der nachfolgenden Verarbeitung keine Ladungen aufbauen;
das weitere Verarbeiten in einer Plasmaumgebung, in der sich normalerweise elektrische Ladungen am Gateoxid der integrierten Schaltung aufbauen würden, wobei die elektrische Unterbrechung den Ladungsaufbau jedoch verhindert;
das Ausbilden und Strukturieren einer weiteren Isolierschicht (56), um Öffnungen für die Durchverbindungen (58) zur Metallschicht zu schaffen;
das Ausbilden einer weiteren Schicht (40) aus Metall über den großen Anschlußflächenbereichen und über der elektrischen Unterbrechung, so daß die weitere Metallschicht elektrisch mit der ersten Metallschicht verbunden ist, und zwar über einen direkten Kontakt zur Metallschicht an den großen Anschlußflächenbereichen und durch die Öffnungen in der weiteren Isolierschicht, wodurch die großen Anschlußflächenbereiche und die integrierte Schaltung wieder elektrisch verbunden werden; und
das Ausbilden einer Passivierungsschicht (60) über der weiteren Metallschicht.

6. Verfahren nach Anspruch 5, wobei die Verarbeitung in einer Plasmaumgebung eine plasmagestützte chemische Dampfabscheidung ist.

7. Verfahren nach Anspruch 5, wobei die Verarbeitung in einer Plasmaumgebung Plasmaätzen ist.

8. Verfahren nach Anspruch 7, wobei das Plasmaätzen eine Sputterätzung ist.

9. Verfahren nach irgendeinem der Ansprüche 5 bis 8, wobei man die weitere Metallschicht strukturiert, um eine zweite elektrische Unterbrechung (100) zwischen den großen Anschlußflächenbereichen und der integrierten Schaltung auszubilden, umfassend:
das weitere Verarbeiten in einer Plasmaumgebung, die normalerweise elektrische Ladungen am Gateoxid der integrierten Schaltung aufbauen würde, wobei die zweite elektrische Unterbrechung den Ladungsaufbau jedoch verhindert;
das Ausbilden und Strukturieren einer zusätzlichen Isolierschicht (104), um Öffnungen für die Durchverbindung (102) zu der weiteren Metallschicht zu schaffen;
das Ausbilden einer zusätzlichen Schicht (106) aus Metall über den großen Anschlußflächenbereichen und über der zweiten elektrischen Unterbrechung, so daß die zusätzliche Metallschicht elektrisch mit der weiteren Metallschicht verbunden ist, und zwar über einen direkten Kontakt zur weiteren Metallschicht an den großen Anschlußflächenbereichen und durch die Öffnungen in der zusätzlichen Isolierschicht, wodurch die großen Anschlußflächenbereiche und die integrierte Schaltung wieder elektrisch verbunden werden; und
das Ausbilden der Passivierungsschicht über der zusätzlichen Metallschicht.

## Revendications

1. Procédé de traitement par un plasma d'un circuit intégré MOS, ayant à ses surfaces des premières grandes régions métalliques (10) qui sont connectées électriquement aux structures (22) de dispositifs, le procédé comprenant la séquence suivante d'étapes :
(a) la formation d'une discontinuité électrique (30) (100) dans la connexion (18)(40) entre les premières grandes régions métalliques et les structures des dispositifs de manière que les premières grandes régions métalliques soient isolées électriquement des structures des dispositifs,
(b) la disposition du circuit intégré dans une chambre pour l'exécution du traitement par un plasma,
(c) le traitement du circuit intégré dans une opération avec un plasma dans laquelle la discontinuité entre les premières grandes régions métalliques et les structures des dispositifs empêche la détérioration des structures des dispositifs,
(d) l'extraction du circuit intégré de la chambre, et
(e) la reconnexion électrique des premières grandes régions métalliques aux structures des dispositifs par une autre couche métallique (40) (106).

2. Procédé selon la revendication 1, dans lequel la dimension des premières grandes régions métalliques est supérieure à 30 x 30 µm environ.

3. Procédé selon la revendication 1 ou 2, dans lequel une autre couche métallique et les premières régions métalliques sont séparées par une matière isolante (56) (104) dans laquelle sont formées des traversées (58)(102) destinées à reconnecter les premières grandes régions aux structures des dispositifs.

4. Procédé selon la revendication 1, 2 ou 3, dans lequel les premières grandes régions métalliques constituent des plages disposées à la périphérie du circuit intégré.

5. Procédé de formation d'une interconnexion conductrice à plusieurs niveaux mettant en oeuvre le procédé de la revendication 4, le procédé de formation d'une interconnexion comprenant :
la formation d'une couche de silicium polycristallin conducteur (14) suivant des motifs sur un substrat (50) de silicium pour la formation d'un premier contact conducteur avec le circuit intégré,
la formation d'une couche isolante (54) sur la couche de silicium polycristallin,
la formation d'ouvertures dans la couche de silicium polycristallin à travers la couche isolante,
la formation d'une couche (18) d'un métal sur la couche isolante afin que la couche métallique soit connectée électriquement au silicium polycristallin par les ouvertures,
la formation des grandes surfaces de plages de contact avec la couche métallique,
la mise sous forme de motifs de la couche métallique pour la réalisation d'une discontinuité électrique (30) dans celle-ci et pour l'isolement électrique des grandes surfaces de plages de contact et du circuit intégré et pour éviter l'accumulation des charges lors d'un traitement ultérieur,
le traitement ultérieur dans un milieu en présence de plasma, tel que le traitement produirait normalement une accumulation des charges électriques dans l'oxyde de grille du circuit intégré, mais que la discontinuité électrique empêche cette accumulation des charges,
la formation et la mise sous forme de motifs d'une autre couche isolante (56) pour la formation d'ouvertures destinées à des traversées (58) rejoignant la couche métallique,
la formation d'une autre couche (40) d'un métal sur les grandes surfaces de plages de contact et sur la discontinuité électrique afin que l'autre couche métallique soit connectée électriquement à la première couche métallique par contact direct avec la couche métallique au niveau des grandes surfaces de plages de contact et par les ouvertures formées dans l'autre couche isolante de manière que les grandes surfaces de plages de contact et le circuit intégré soient connectés électriquement à nouveau, et
la formation d'une couche (60) de passivation sur l'autre couche métallique.

6. Procédé selon la revendication 5, dans lequel le traitement dans un milieu en présence d'un plasma est un dépôt chimique en phase vapeur en présence d'un plasma.

7. Procédé selon la revendication 5, dans lequel le traitement dans un milieu en présence d'un plasma est une attaque par un plasma.

8. Procédé selon la revendication 7, dans lequel l'attaque par un plasma est une attaque par pulvérisation cathodique.

9. Procédé selon l'une quelconque des revendications 5 à 8, qui comprend la mise sous forme de motifs d'autres couches métalliques pour la formation d'une seconde discontinuité électrique (100) entre les grandes surfaces de plages de contact et le circuit intégré,
le traitement supplémentaire dans un milieu en présence d'un plasma, tel que le traitement produirait normalement une accumulation de charges électriques dans l'oxyde de grille du circuit intégré, mais que la seconde discontinuité électrique empêche cette accumulation de charges,
la formation et la mise sous forme de motifs d'une couche isolante supplémentaire (104) pour la réalisation d'ouvertures destinées à une traversée (102) rejoignant l'autre couche métallique,
la formation d'une couche supplémentaire (106) d'un métal sur les grandes surfaces de plages de contact et sur la seconde discontinuité électrique afin que la couche métallique supplémentaire soit connectée électriquement à l'autre couche métallique, par contact direct avec l'autre couche métallique par les grandes surfaces de plages de contact et dans les ouvertures formées dans la couche isolante supplémentaire, si bien que les grandes surfaces de plages de contact et le circuit intégré sont connectés électriquement à nouveau, et la formation de la couche de passivation sur la couche métallique supplémentaire.
